# EUROPÄISCHE PATENTANMELDUNG

(11) **EP 0 726 472 A2**
(43) Veröffentlichungstag der Anmeldung: **14.08.1996**
(21) Anmeldenummer: 96100594.9
(22) Anmeldetag: 17.01.1996
(51) Int. Cl.: G01R 31/36

(54) **Elektronische Batterieüberwachungseinrichtung**

(30) Priorität: 07.02.1995 DE 19503917
(71) Anmelder: MC Micro Compact Car Aktiengesellschaft, CH-2500 Biel 4 (CH)
(72) Erfinder: Edye, Thomas, CH-2017 Boudry (CH); Reghenzi, Paolo, CH-2730 Tavanes (CH); De Santo, Antonio, CH-2800 Delémont (CH)

(57) **Zusammenfassung**

2.1. Beispielsweise für Traktionsbatterien von Elektrofahrzeugen ist es bekannt, die Batterie aus mehreren physikalisch voneinander getrennten Blöcken aufzubauen. Wünschenswert ist dabei eine Überwachung des Zustands der einzelnen Batterieblöcke mit möglichst geringem Aufwand.

2.2. Es wird eine elektronische Überwachungseinrichtung für eine aus mehreren Blöcken aufgebaute Batterie vorgeschlagen, die für jeden Block einen von der Batterie gespeisten, eigenen Meßschaltkreisbaustein, einen die Meßschaltkreisbausteine miteinander verbindenden, seriellen Datenbus sowie eine zentrale Datenverarbeitungseinheit umfaßt, die außerhalb der Batterie angeordnet und an den seriellen Datenbus angeschlossen ist. Auf diese Weise wird mit geringem Aufwand eine in die Batterie integrierte Datenerfassungs- und Datenspeicherungselektronik bereitgestellt, während der höhere Elektronikaufwand zur Datenauswertung batterieextern angeordnet ist und bei einem Batterieaustausch erhalten bleibt. Die Verwendung des seriellen Datenbusses ermöglicht es, mit einem minimalen Verkabelungsaufwand auszukommen.

2.3. Verwendung z.B. in Elektrofahrzeugen.

## Beschreibung

Die Erfindung bezieht sich auf eine elektronische Überwachungseinrichtung für eine aus mehreren, physikalisch voneinander getrennten Blöcken aufgebaute Batterie nach dem Oberbegriff des Anspruchs 1. Einen wichtigen Anwendungsfall bilden Traktionsbatterien für Elektrofahrzeuge, die häufig in dieser Weise aufgebaut sind. Die Lebensdauer heutiger Traktionsbatterien ist dabei meist wesentlich geringer als die Lebensdauer des Fahrzeuges. Bei konventionellen elektronischen Überwachungseinrichtungen für Traktionsbatterien ist die Batteriedatenerfassung und Batteriedatenspeicherung üblicherweise so ausgeführt, daß sie bei einem Batteriewechsel bestehen bleiben. Die konventionellen elektronischen Überwachungseinrichtungen ohne Ringleitungssystem erfordern einen relativ hohen Verkabelungsaufwand zur Erfüllung der diversen Elektronikfunktionen.

Einrichtungen der eingangs genannten Art sind in den Offenlegungsschriften DE 34 12 541 A1 und DE 37 02 591 A1 beschrieben. Die dortigen Ringleitungssysteme sind von einfachen elektrischen Steuer- und/oder Meßsignalleitungen gebildet, wobei die Meßdaten nacheinander von den einzelnen Meßschaltkreisbausteinen abgefragt werden, entweder durch ein adresskodiertes Steuersignal von der Zentraleinheit oder durch sukzessive Steuersignalweitergabe von einem Meßschaltkreisbaustein zum nächsten. Die Meßdaten werden der Zentraleinheit übermittelt, ohne daß die einzelnen Meßschaltkreisbausteine darauf Zugriff haben.

Der Erfindung liegt als technisches Problem die Bereitstellung einer elektronischen Überwachungseinrichtung der eingangs genannten Art zugrunde, mit der sich bei geringem Verkabelungsaufwand in einfacher Weise eine zuverlässige und komfortable Überwachung des Batteriezustands erreichen läßt.

Dieses Problem wird durch eine elektronische Batterieüberwachungseinrichtung mit den Merkmalen des Anspruchs 1 oder 2 gelöst. Jedem Batterieblock ist ein eigener, von der Batterie gespeister Meßschaltkreisbaustein zugeordnet, welcher die erforderlichen Meßgrößen erfaßt, wie Spannung und Temperatur des betreffenden Batterieblocks. Die einzelnen Meßschaltkreisbausteine sind über einen einfachen seriellen Datenbus mit geringstem Verkabelungsaufwand untereinander verbunden. An den seriellen Datenbus ist außerdem eine zentrale Datenverarbeitungseinheit angeschlossen, die außerhalb der Batterie angeordnet ist. Diese Datenverarbeitungseinheit wertet die Batteriezustandsdaten aus und beinhaltet die aufwendigeren Elektronikfunktionen, z.B. einen Mikroprozessor. Bei einem Batterieaustausch, wie er im Fall einer Fahrzeugtraktionsbatterie von Zeit zu Zeit erforderlich ist, bleiben daher die aufwendigeren Elektronikfunktionen im Fahrzeug erhalten, während die einfachen Elektronikfunktionen in Form der Meßschaltkreisbausteine und des seriellen Datenbusses zur Meßdatengewinnung und -übertragung in die Batterie integriert sind und dementsprechend mit dieser entsorgt werden. Ein Batterieaustausch macht daher lediglich das Abkoppeln des seriellen Datenbusses von der zentralen Datenverarbeitungseinheit sowie der Batteriepole von der abführenden Batteriestromleitung und entsprechend deren Wiederankoppeln erforderlich.

Bei der Einrichtung nach Anspruch 1 ist ein zentraler Datenspeicher vorgesehen, der physikalisch an einen der Batterieblöcke gebunden und an den seriellen Datenbus angeschlossen ist. Der bevorzugt nichtflüchtig ausgelegte Datenspeicher, der die batterierelevanten Daten speichert, wird folglich bei einem Batterieaustausch nicht wiederverwendet. Er kann bevorzugt so eingerichtet sein, daß er gegen unberechtigte Manipulationen geschützt ist. Dies kann vor allem für eigenständige Batteriesysteme, wie für Leasingbatterien, zweckmäßig sein.

Die Einrichtung nach Anspruch 2 erlaubt eine größtmögliche Vereinfachung des seriellen Datenbusses, indem sämtliche Meßdaten aller Meßschaltkreisbausteine in Meßdatenpaketen übertragen werden. Jeder Meßschaltkreisbaustein entnimmt dem über den Datenbus laufenden jeweiligen Meßpaket die von ihm benötigten Informationen und fügt die selbstgewonnenen Meßdaten hinzu. Zweckmäßig sind Protokoll und Übermittlungsformat auf dem seriellen Datenbus so realisiert, daß die einzelnen Meßschaltkreisbausteine einen identischen Hardwareaufbau besitzen können.

Die in einer Weiterbildung der Erfindung nach Anspruch 3 vorgesehene, kapazitive Kopplung der Meßschaltkreisbausteine untereinander ist sehr kostengünstig realisierbar, insbesondere im Vergleich zu einer alternativ möglichen Verbindung der Meßschaltkreisbausteine über Optokoppler.

Eine bevorzugte Ausführungsform der Erfindung ist in den Zeichnungen dargestellt und wird nachfolgend beschrieben. Hierbei zeigen:
- Fig. 1: eine schematische Darstellung eines Traktionsbatteriesystems mit integrierten Komponenten einer elektronischen Überwachungseinrichtung,
- Fig. 2: eine schematische Darstellung eines bestimmten Batterieblocks des Systems von Fig. 1 mit zugehörigem elektronischem Überwachungsteil und integriertem, zentralem Datenspeicher und
- Fig. 3: eine schematische Darstellung eines in ein Elektrofahrzeug eingebauten Batteriesystems nach den Figuren 1 und 2 mit zugehöriger Antriebselektronikeinheit.

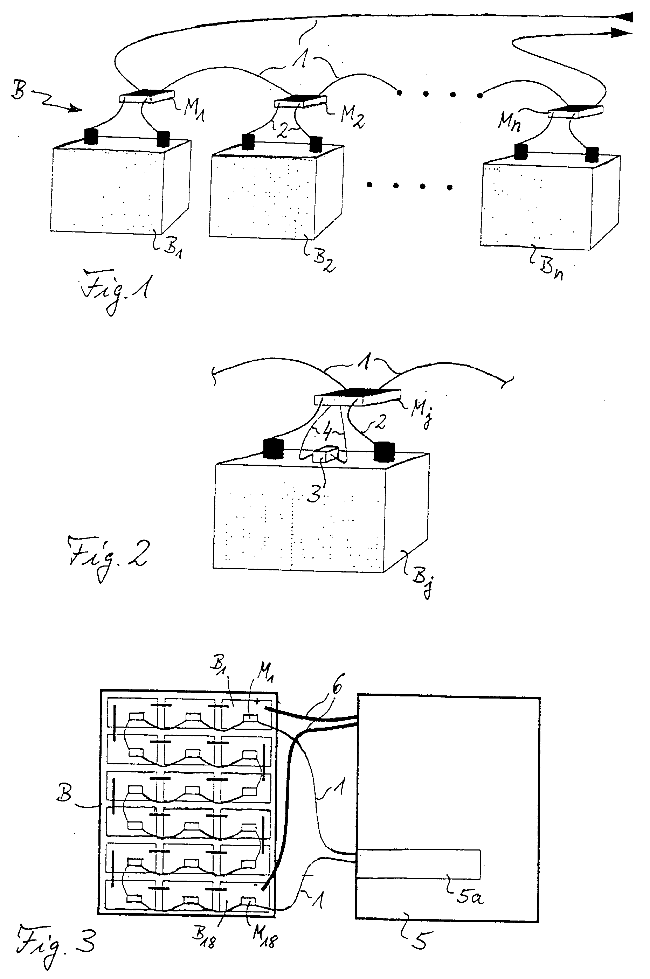

In Fig. 1 ist schematisch eine Traktionsbatterie (B) für ein Elektrofahrzeug gezeigt, die aus einer Anzahl n (n>1) einzelner, physikalisch voneinander getrennter Batterieblöcke (B₁,...,Bₙ) besteht. Die Batterieblöcke (B₁ bis Bₙ) erzeugen typischerweise jeweils dieselbe Spannung zwischen 12V und 24V. Zur Batterieüberwachung werden von jedem Batterieblock (B₁ bis Bₙ) die Batteriespannung und die Batterietemperatur erfaßt. Hierzu ist für jeden Batterieblock (B₁ bis Bₙ) jeweils ein kleiner, durch die Batterie (B) gespeister elektronischer Meßschaltkreisbaustein (M₁,...,Mₙ) vorgesehen, der die benötigten Messungen vornimmt. Die Meßschaltkreisbausteine (M₁ bis Mₙ) sind über einen sehr einfachen seriellen Datenbus (1) miteinander verbunden. Die Kopplung zwischen den einzelnen Meßschaltkreisbausteinen (M₁ bis Mₙ) ist kapazitiv ausgeführt, was bei den erzeugten Spannnungen der einzelnen Blöcke von zwischen etwa 12V bis 24V problemlos möglich ist. Die kapazitive Kopplung ist kostengünstiger als eine alternativ realisierbare Kopplung über Optokoppler. Zur Aufnahme der Meßdaten ist jeweils eine Meßfühlerleitung (2) zwischen dem jeweiligen Meßschaltkreisbaustein (M₁ bis Mₙ) und der zugehörigen Meßstelle im Batterieblock (B₁ bis Bₙ) vorgesehen.

Die einzelnen Meßschaltkreisbausteine (M₁ bis Mₙ) besitzen einen identischen Hardwareaufbau, wozu das Datenprotokoll und das Datenübermittlungsformat auf dem seriellen Datenbus geeignet gewählt sind, wie dies dem Fachmann bei serieller Datenübertragung geläufig ist. Sämtliche Dateninformationen gehen in Form von Meßpaketen durch alle Meßschaltkreisbausteine (M₁ bis Mₙ). Jeder Meßschaltkreisbaustein (M₁ bis Mₙ) entnimmt von jedem Meßpaket die Informationen, die er selbst benötigt, und fügt dem Meßpaket seine eigenen Meßwerte hinzu. Dies macht es möglich, zur Datenübertragung mit dem sehr einfach aufgebauten, seriellen Datenbus (1) auszukommen.

Werden die Meßschaltkreisbausteine (M₁ bis Mₙ) in CMOS-Technologie ausgeführt, was wegen der geringen Leistungsaufnahme der Bausteine von Vorteil ist, muß beachtet werden, daß eine maximale Betriebsspannung z.B. 15V nicht überschritten werden darf. Bei einer lokalen Speisung der Meßschaltkreisbausteine (M₁ bis Mₙ) durch die Batterieblöcke (B₁ bis Bₙ) muß daher jeweils ein Spannungsregler vorgeschaltet werden, wenn die von den eingesetzten Blöcken erzeugte Spannung die maximale Betriebsspannung der Bausteine übersteigt. In diesem Fall kann es vorteilhafter sein, daß die Meßschaltkreisbausteine (M₁ bis Mₙ) ihren Betriebsstrom über die kapazitive Kopplung an den seriellen Datenbus (1) einer Trägerfrequenz entnehmen. Der Anschluß der Meßschaltkreisbausteine (M₁ bis Mₙ) an die Batterieblöcke (B₁ bis Bₙ) dient dann nur der Messung der Batteriespannung.

Über reine Meßfunktionen hinaus können in den Meßschaltkreisbausteinen (M₁ bis Mₙ) auch Funktionen integriert sein, die aktiv Lade- oder Entladevorgänge der jeweils zugeordneten Batterieblöcke (B₁ bis Bₙ) beeinflussen. Dies kann dadurch realisiert sein, daß über Meßfühlerleitungen (2) oder andere nicht eigens in der Zeichnung dargestellte Leitungen, die mit den jeweiligen Polen der Batterieblöcke (B₁ bis Bₙ) verbunden sind, ein Ausgleichsstrom geleitet wird, der durch jeweils einen in die Meßschaltkreisbausteinen (M₁ bis Mₙ) integrierten, individuell regelbaren Parallelwiderstand steuerbar ist. Eine solche Ausgleichsschaltung ist insbesondere dann von Vorteil, wenn es nicht möglich ist, den Ladezustand der Batterieblöcke (B₁ bis Bₙ) untereinander durch Überladen auszugleichen, wie dies aufgrund der damit verbundenen Explosionsgefahr bei Lithium-Batterien der Fall ist: Da die einzelnen Batterieblöcke (B₁ bis Bₙ) Unterschiede in ihrer Kapazität aufweisen, werden beim Wiederaufladen der Batterie einige Batterieblöcke (B₁ bis Bₙ) schon voll sein und andere nicht. Wenn, wie bei Lithium-Batterien, der Vergasungspunkt jedoch unbedingt gemieden werden muß, ist eine Ausgleichsschaltung unverzichtbar, um alle Batterieblöcke (B₁ bis Bₙ) maximal voll laden zu können. Die Ansteuerung der Ausgleichsfunktion kann ebenfalls über den seriellen Datenbus (1) erfolgen.

In einem (Bⱼ; 1≦j≦n) der Batterieblöcke ist ein zentraler, nichtflüchtiger Datenspeicher (3) integriert, wie dies in Fig. 2 dargestellt ist. Der z.B. als RAM oder EEPROM-Baustein realisierte Datenspeicher (3) speichert die batterierelevanten Daten. Der Speicherbaustein (3) ist fest mit dem ausgewählten Batterieblock (Bⱼ) vergossen und damit physikalisch an diesen Block (Bⱼ) gebunden. Die abgespeicherten Daten beinhalten unter anderem eine Information über die Anzahl von Lade- bzw. Entladezyklen, über Tiefentladungen, über Extremwerte usw.. Die solchermaßen fest an die Antriebsbatterie (B) gebundene Datenspeicherung ist zudem durch geeignete Maßnahmen vor unbefugter Manipulation geschützt. Dies ist vor allem für Leasingbatterien und Service-Dienstleistungspakete von Batterieherstellern zweckmäßig, da auf diese Weise der Batterielieferant durch späteren Abruf der gespeicherten Daten eine manipulationsgesicherte Information über den Betriebsverlauf der Batterie (B) während Ihrer Lebensdauer gewinnen kann. Über eine Verbindungsleitung (4) ist der zentrale Datenspeicherbaustein (3) an den zu seinem Batterieblock (Bⱼ) gehörigen Meßschaltkreisbaustein (Mⱼ) und über diesen an den seriellen Datenbus (1) angekoppelt. Die abzuspeichernden Daten fließen auf diese Weise über den seriellen Datenbus (1).

Fig. 3 zeigt den Einsatz einer derartigen Traktionsbatterie (B) mit elektronischer Überwachung in einem Elektrofahrzeug, wobei die Batterie (B) an eine Antriebselektronikeinheit (5) des Elektrofahrzeugs angekoppelt ist. Die Traktionsbatterie (B) besteht hier beispielhaft aus 18 einzelnen Batterieblöcken (B₁ bis B₁₈), die, wie durch die dicken Stromleitungsverbindungen angedeutet, seriell hintereinandergeschaltet sind. Ein Starkstromkabel (6) verbindet die Antriebselektronikeinheit (5) mit dem Pluspol des ersten Batterieblocks (B₁) und dem Minuspol des letzten Batterieblocks (B₁₈) zur Führung des Entlade- bzw. Ladestroms. Des weiteren ist die Antriebselektronikeinheit (5) über eine geeignete Schnittstelle (5a) an den seriellen Datenbus (1) angeschlossen. Zur Batteriezustandsbestimmung wird außer den Spannungs- und Temperaturmessungen in den einzelnen Batterieblöcken (B₁ bis B₁₈) zusätzlich der kummulierte Batteriestrom genau erfaßt, was von der Antriebselektronikeinheit (5) durchgeführt wird, zu der das Batteriestarkstromkabel (6) geführt ist. Gleichzeitig übernimmt die Antriebselektronikeinheit (5), die über einen geeigneten Mikroprozessor verfügt, die Auswertung der über den seriellen Datenbus (1) übertragenen Zustandsdaten der einzelnen Batterieblöcke (B₁ bis B₁₈). Der Rechenaufwand für diese Datenverarbeitung ist auf diese Weise vollständig in die Antriebselektronikeinheit (5) verlagert, so daß in der Traktionsbatterie (B) keine Datenverarbeitungskapazität erforderlich ist. Die Meßschaltkreisbausteine (M₁ bis M₁₈) brauchen daher lediglich hinsichtlich Datenerfassung und Datenspeicherung ausgelegt sein. Über den seriellen Datenbus (1) fließen die in der Antriebselektronik (5) auszuwertenden, von den einzelnen Meßschaltkreisbausteinen (M₁ bis M₁₈) gewonnenen Daten sowie die in dem zentralen Datenspeicher (3), der gemäß Fig. 2 in einen der Batterieblöcke (B₁ bis B₁₈) integriert ist, was in Fig. 3 der Einfachheit halber nicht nochmals explizit dargestellt ist, abzuspeichernden Daten.

In der Batterie (B) befindet sich folglich nur ein Minimum an aufwendigen Elektronikfunktionen bei gleichzeitig minimalem Verkabelungsaufwand. Die über die Datenerfassung und Datenspeicherung hinausgehenden Elektronikfunktionen werden von der Antriebselektronikeinheit (5) übernommen, z.B. eine gegebenenfalls für die Traktionsbatterie (B) erforderliche Lüftungs- und/oder Heizungssteuerung.

Die Erfindung realisiert folglich eine in das Batteriesystem integrierte Datenerfassungs- und Datenspeicherungselektronik, die mit dem Batteriesystem ausgetauscht und entsorgt wird, während die Datenverarbeitungselektronik in einer batteriesystemexternen Einheit untergebracht wird. Diese Auslegung einer elektronischen Batterieüberwachungseinrichtung ist einfach und kostengünstig herstellbar und benötigt nur geringen Verkabelungsaufwand.

## Patentansprüche

1. Elektronische Überwachungseinrichtung für eine aus mehreren physikalisch voneinander getrennten Blöcken (B₁,..,Bₙ) aufgebaute Batterie (B), insbesondere eine Traktionsbatterie für ein Elektrofahrzeug, mit
- jeweils einem von der Batterie gespeisten, eigenen Meßschaltkreisbaustein (M₁ bis Mₙ) für jeden Batterieblock (B₁ bis Bₙ),
- einem Ringleitungssystem, das die Meßschaltkreisbausteine miteinander verbindet, und
- einer Zentraleinheit (5), die außerhalb der Batterie (B) angeordnet und an das Ringleitungssystem angeschlossen ist, **dadurch gekennzeichnet, daß**
- das Ringleitungssystem ein serieller Datenbus (1) ist und die Zentraleinheit eine zentrale Datenverarbeitungseinheit (5) ist, wobei die zentrale Datenverarbeitungseinheit und die Meßschaltkreisbausteine (M₁ bis Mₙ) datenbuskommunikationsfähig ausgelegt sind, und
- ein zentraler Datenspeicher (3) vorgesehen ist, der physikalisch an einen (Bⱼ) der Batterieblöcke gebunden und an den seriellen Datenbus (1) angeschlossen ist.

2. Elektronische Überwachungseinrichtung für eine aus mehreren physikalisch voneinander getrennten Blöcken (B₁,...,Bₙ) aufgebaute Batterie (B), insbesondere nach Anspruch 1, mit
- jeweils einem von der Batterie gespeisten, eigenen Meßschaltkreisbaustein (M₁ bis Mₙ) für jeden Batterieblock (B₁ bis Bₙ),
- einem Ringleitungssystem, das die Meßschaltkreisbausteine miteinander verbindet, und
- einer Zentraleinheit (5), die außerhalb der Batterie (B) angeordnet und an das Ringleitungssystem angeschlossen ist,
**dadurch gekennzeichnet, daß**
- das Ringleitungssystem ein serieller Datenbus (1) ist und die Zentraleinheit eine zentrale Datenverarbeitungseinheit (5) ist, wobei die zentrale Datenverarbeitungseinheit und die Meßschaltkreisbausteine (M₁ bis Mₙ) datenbuskommunikationsfähig ausgelegt sind, und
- sämtliche Meßdaten aller Meßschaltkreisbausteine (M₁ bis Mₙ) in Meßdatenpaketen, auf die alle Meßschaltkreisbausteine Zugriff haben, über den seriellen Datenbus (1) übertragen werden.

3. Elektronische Batterieüberwachungseinrichtung nach Anspruch 1 oder 2, weiter
**dadurch gekennzeichnet, daß**
die Meßschaltkreisbausteine (M₁ bis Mₙ) untereinander kapazitiv gekoppelt sind.

4. Elektronische Batterieüberwachungseinrichtung nach einem der Ansprüche 1 bis 3, weiter
**dadurch gekennzeichnet, daß**
den Meßschaltkreisbausteinen (M₁ bis Mₙ) der von ihnen benötigte Betriebsstrom vermittels des seriellen Datenbusses (1) zugeführt wird.

5. Elektronische Battiereüberwachungseinrichtung nach einem der Ansprüche 1 bis 3, weiter
**dadurch gekennzeichnet, daß**
die Meßschaltkreisbausteine (M₁ bis Mₙ) den von ihnen benötigten Betriebsstrom dem jeweils zugeordneten Batterieblock (B₁ bis Bₙ) entnehmen.

6. Elektronische Batterieüberwachungseinrichtung nach Anspruch 5, weiter
**dadurch gekennzeichnet, daß**
in die Meßschaltkreisbausteine (M₁ bis Mₙ) jeweils ein regelbarer Parallelwiderstand integriert ist, der die Pole des jeweils zugeordneten Batterieblocks (B₁ bis Bₙ) überbrückt und der so regelbar ist, daß der jeweilig zugeordneten Batterieblock (B₁ bis Bₙ) vor Überladung geschützt ist.
